(19) Europäisches Patentamt / European Patent Office / Office européen des brevets

(11) **EP 4 310 517 B1**

(12) **EUROPEAN PATENT SPECIFICATION**

(45) Date of publication and mention of the grant of the patent:
**14.01.2026 Bulletin 2026/03**

(21) Application number: **22913480.4**

(22) Date of filing: **07.09.2022**

(51) International Patent Classification (IPC):
**G01R 22/10** (2006.01) **G01R 22/06** (2006.01)

(52) Cooperative Patent Classification (CPC):
**G01R 22/10; G01R 22/063**

(86) International application number:
**PCT/CN2022/117428**

(87) International publication number:
**WO 2023/124206 (06.07.2023 Gazette 2023/27)**

(54) **SINGLE-PHASE ELECTRIC ENERGY METERING CHIP AND INTELLIGENT INTERNET-OF-THINGS METER BASED ON IR46 STANDARD**

EINPHASEN-STROMMESSCHIP UND INTELLIGENTER INTERNET-DER-DINGE-ZÄHLER AUF DER BASIS DES IR46-STANDARDS

PUCE DE MESURE DE L'ÉNERGIE ÉLECTRIQUE MONOPHASÉE ET COMPTEUR INTELLIGENT DE L'INTERNET DES OBJETS BASÉ SUR LA NORME IR46

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **27.12.2021 CN 202111614842**

(43) Date of publication of application:
**24.01.2024 Bulletin 2024/04**

(73) Proprietor: **Hangzhou Vango Technologies, Inc.**
**Hangzhou, Zhejiang 310053 (CN)**

(72) Inventors:
• **CHEN, Bo**
**Hangzhou, Zhejiang 310053 (CN)**
• **MEN, Changyou**
**Hangzhou, Zhejiang 310053 (CN)**
• **CUI, Guoyu**
**Hangzhou, Zhejiang 310053 (CN)**

(74) Representative: **HGF**
**HGF Limited**
**4th Floor, 1 City Square**
**Leeds LS1 2AL (GB)**

(56) References cited:
| | |
|---|---|
| CN-A- 106 610 450 | CN-A- 106 610 450 |
| CN-A- 108 535 539 | CN-A- 109 270 341 |
| CN-A- 111 650 435 | CN-A- 112 230 052 |
| CN-A- 112 305 303 | CN-A- 112 698 068 |
| CN-A- 114 325 089 | CN-U- 206 321 704 |
| CN-U- 210 294 397 | CN-U- 213 149 075 |
| CN-U- 214 174 475 | CN-U- 214 174 475 |
| US-A1- 2014 046 609 | |

**Description**

**TECHNICAL FIELD**

The present invention belongs to the field of electric power, and particularly relates to a single-phase electric energy metering chip and intelligent Internet of Things meter based on an IR46 standard.

**BACKGROUND**

A new-generation single-phase intelligent Internet of Things electric energy meter adopts a multi-module design, and mainly comprises a metering core module and a management core module, wherein the metering core module is mainly responsible for electric energy metering, and the management core module is responsible for data processing and other services, and there is a large amount of data interaction between the two modules. Moreover, electrical isolation needs to be performed between the two modules. There is no single-phase metering chip that meets requirements in the market at present, the metering core module can only be implemented by a single-phase metering SOC (System on Chip) chip, which is namely a MCU (Microcontroller Unit) with a metering module, there are many interfaces with complicated functions between the metering core module and the management core module in the implementation mode, and there is frequent data exchange between the management core module and the metering core module, so that there are always the problems of electrical isolation and reliable connection between modules.

IR46: International Recommendation 46, International recommendations for active electric energy meters.

Chinese patent publication No. CN214174475U discloses a single-phase smart meter and its metering module, which comprises a metering chip that communicates with the electric supply and is used for metering electric energy parameters, a metering MCU that is connected with the metering chip, a management MCU that is connected to the metering MCU, and an isolation circuit that is connected to the signal interface of the metering chip and the signal interface of the metering MCU and is used for forming an electrical isolation between the two. However, the full-wave data, the harmonic data and the original waveform data that the single-phase smart meter sends to the metering MCU, the management MCU and the function expansion modules are not corrected. The metering MCU, the management MCU and the function expansion modules need to correct the data, so that cannot guarantee the real-time performance of data.

**SUMMARY**

Object of invention: the technical problem to be solved by the present invention is to provide a single-phase electric energy metering chip and intelligent Internet of Things meter based on an IR46 standard aiming at the defects in the prior art.

In order to solve the above technical problem, in a first aspect, a single-phase electric energy metering chip based on an IR46 standard is disclosed, which comprises a current and voltage signal acquisition and correction unit, a full-wave measurement and metering unit, a harmonic measurement and metering unit, an original sampled data processing unit, a terminal temperature measurement unit, a communication interface, an energy output interface and an original waveform data output port, wherein,

the current and voltage signal acquisition and correction unit is configured for performing analog-to-digital conversion on a voltage signal and a current signal, and performing phase and gain correction on the signals subjected to the analog-to-digital conversion to obtain corrected data of the voltage signal and corrected data of the current signal;

the full-wave measurement and metering unit is configured for calculating and obtaining full-wave data according to the corrected data of the voltage signal and the corrected data of the current signal, and the full-wave data comprises a full-wave effective value, full-wave power, a grid frequency, a power factor and full-wave energy data;

the harmonic measurement and metering unit is configured for calculating and obtaining harmonic data according to the corrected data of the voltage signal and the corrected data of the current signal, and the harmonic data comprises a harmonic effective value, harmonic power and harmonic energy data;

the original waveform data processing unit is configured for processing the corrected data of the voltage signal and/or the corrected data of the current signal to obtain waveform data;

the terminal temperature measurement unit comprises acquisition and correction of a temperature measurement signal, and is configured for measuring and monitoring temperatures of four wiring terminals of an electric energy meter to obtain terminal temperature measurement data;

the communication interface is configured for communicating with a metering main control chip, and the metering main control chip controls the single-phase electric energy metering chip through the communication interface, and reads the full-wave data, the harmonic data and the terminal temperature measurement data;

the energy output interface is configured for outputting the full-wave energy data and the harmonic energy data; and

the original waveform data output port is configured for outputting the waveform data in an active output mode.

In combination with the first aspect, optionally, the current signal comprises a live wire current signal and a zero wire current signal, and the current and voltage signal acquisition and correction unit comprises a first acquisition and correction subunit, a second acquisition and correction subunit and a third acquisition and correction subunit,

the first acquisition and correction subunit comprises a first analog-to-digital converter and a voltage signal channel, the first analog-to-digital converter is configured for performing the analog-to-digital conversion on the voltage signal to obtain a voltage digital signal; and the voltage signal channel is configured for performing the phase and gain correction on the voltage digital signal to obtain the corrected data of the voltage signal;
the second acquisition and correction subunit and the third acquisition and correction subunit both comprise a first analog-to-digital converter, a digital integrator and a current signal channel, and the current signal channel and the voltage signal channel have the same structure; and
considering sampling synchronization of the voltage and current signals, three completely independent first analog-to-digital converters are needed to sample the voltage and current signals.

The second acquisition and correction subunit is input with the live wire current signal and outputs corrected data of the live wire current signal; the third acquisition and correction subunit is input with the zero wire current signal and outputs corrected data of the zero wire current signal; and the live wire and zero wire current signals are separately subjected to phase-angle and gain correction, with a correction resolution capable of reaching one ten-thousandth. When the live wire current signal and the zero wire current signal are sampled and obtained by a Rogowski coil, the digital integrator is turned on; and when the live wire current signal and the zero wire current signal are obtained by other means, such as a resistor and a current transformer, the digital integrator is turned off. The corrected data comprises a direct-current component mean value, non-high-pass data, high-pass data, asynchronously sampled data and synchronously sampled data of a corresponding signal, and the asynchronously sampled data and the synchronously sampled data are output in a DMA (Direct Memory Access) mode.

The non-high-pass data, the high-pass data, the asynchronously sampled data and the synchronously sampled data of the corresponding signal may be used for calculating effective values, power, energy and the like by the full-wave measurement and metering unit and the harmonic measurement and metering unit; and the asynchronously sampled data and the synchronously sampled data also need to be output to a metering main control chip, a main control chip of a management core module, a main control chip of an extension module 1 and a main control chip of an extension module 2, these main control chips may be used to do some self-operations, and a real-time performance of data can be guaranteed through DMA output.

In combination with the first aspect, optionally, the voltage signal channel comprises a metering correction circuit, and the metering correction circuit comprises a phase correction circuit, a down-sampling circuit, a low-pass filter, a high-pass filter, a direct-current automatic compensation circuit, a first arithmetic unit, a gain correction circuit and a first selector,

the phase correction circuit is configured for performing metering phase correction on the voltage digital signal to obtain metering-phase-corrected data;
the down-sampling circuit is configured for performing down-sampling on the metering-phase-corrected data to obtain down-sampled data;
the low-pass filter is configured for performing low-pass filtration on the down-sampled data to obtain a direct-current component mean value of the voltage signal;
the direct-current automatic compensation circuit is configured for performing direct-current compensation on the direct-current component mean value of the voltage signal to obtain direct-current-compensated data; and when the direct-current automatic compensation circuit is turned off, the direct-current-compensated data is zero;
the first arithmetic unit is configured for subtracting the direct-current-compensated data from the down-sampled data to obtain a first arithmetic value;
the high-pass filter is configured for performing high-pass filtration on the down-sampled data to obtain a second alternating-current component value;
the gain correction circuit is configured for performing metering gain correction on the first arithmetic value and the second alternating-current component value respectively, and after the first arithmetic value passes through the gain correction circuit, non-high-pass data of the voltage signal is obtained; and after the second alternating-current component value passes through the gain correction circuit, high-pass data of the voltage signal is obtained; and
the first selector is configured for selecting the non-high-pass data of the voltage signal or the high-pass data of the voltage signal to obtain asynchronously sampled data of the voltage signal.

In combination with the first aspect, optionally, the voltage signal channel further comprises a waveform correction circuit, and the waveform correction circuit comprises a phase correction circuit, a synchronous sampling circuit, a second arithmetic unit and a gain correction circuit,

the phase correction circuit is further configured for performing waveform phase correction on the voltage digital signal to obtain waveform-phase-corrected data;
the synchronous sampling circuit is configured for performing synchronous sampling on the waveform-phase-corrected data to obtain synchronously sampled data; and
Traditional error correction is changed from traditional separate correction of effective values and power into correction of original data sampled by the first analog-to-digital converter, which has the advantages that: a) the correction is simpler, and b) it is unnecessary to correct the original waveform data transmitted to the management core module and other modules.

The second arithmetic unit is configured for subtracting the direct-current-compensated data from the synchronously sampled data to obtain a third arithmetic value; and
the gain correction circuit is further configured for performing waveform gain correction on the third arithmetic value to obtain synchronously sampled data of the voltage signal.

In combination with the first aspect, optionally, the harmonic effective value comprises M-order harmonic and total harmonic current and voltage effective values, the harmonic power comprises M-order harmonic and total harmonic active and reactive power, and the harmonic energy data comprises M-order harmonic and total harmonic active and reactive energy data; and M represents a total number of harmonic waves, and $1 \leq M \leq 41$;

the harmonic measurement and metering unit comprises an FFT (Fast Fourier Transform) algorithm subunit, a 1-order to M-order harmonic data gain compensation circuit and an energy integration circuit,
the synchronously sampled data of the voltage signal and synchronously sampled data of the current signal are put into a data buffer area inside the single-phase electric energy metering chip as data sources, and the FFT algorithm subunit performs harmonic operation on the synchronously sampled data of the voltage signal and the synchronously sampled data of the current signal every other period $T_{FFT}$ to obtain harmonic operation results;
the 1-order to M-order harmonic data gain compensation circuit performs gain compensation on the harmonic operation results to obtain M-order harmonic current and voltage effective values, M-order harmonic active power and M-order harmonic reactive power respectively; and
the energy integration circuit performs energy integration operation on the M-order harmonic active power and the M-order harmonic reactive power respectively, and after the M-order harmonic active power passes through the energy integration circuit, the M-order harmonic and total harmonic active energy data is obtained; and after the M-order harmonic reactive power passes through the energy integration circuit, the M-order harmonic and total harmonic reactive energy data is obtained.

In combination with the first aspect, optionally, the terminal temperature measurement unit comprises a channel selection subunit, a second analog-to-digital converter, an analog gain circuit and first to fourth gain correction circuits,

the channel selection subunit is configured for selecting a terminal temperature signal from a first live wire terminal, a second live wire terminal, a first zero wire terminal and a second zero wire terminal to enter the second analog-to-digital converter;
the second analog-to-digital converter is configured for performing analog-to-digital conversion on the terminal temperature signal to obtain a terminal temperature digital signal; and
considering an amplitude and a measurement accuracy of the input terminal temperature signal, the second analog-to-digital converter may be different from the first analog-to-digital converter, and an accuracy of the second analog-to-digital converter is 16 bits. Because it is unnecessary to update the temperature data so quickly, only one second analog-to-digital converter is needed for time division multiplexing. An input impedance of the second analog-to-digital converter is required to be above 200 K.

The analog gain circuit is configured for obtaining a terminal temperature gain value from the terminal temperature digital signal; and
the first to fourth gain correction circuits are configured for performing gain correction on a first live wire terminal temperature gain value, a second live wire terminal temperature gain value, a first zero wire terminal temperature gain value and a second zero wire terminal temperature gain value respectively to obtain corresponding temperature effective values.

In combination with the first aspect, optionally, a number of sampling points of each cycle of the first analog-to-digital converter is $N_{ADC1}$, and a synchronous sampling function is needed, which means that, with a change of a power grid frequency, the number of sampling points every cycle is fixed. In order to ensure a bandwidth of metering, $N_{ADC1} \geq 128$, and accuracy of the first analog-to-digital converter is 22 bits, so that the corrected data of the voltage signal and the corrected data of the current signal are 22 bits.

In combination with the first aspect, optionally, the original waveform data processing unit comprises a channel selection subunit, an output point number processing subunit and a data framing processing subunit,

the channel selection subunit is configured for selecting the waveform data to output the corrected data of the voltage signal and/or the corrected data of the current signal, and selecting the asynchronously sampled data or the synchronously sampled data in the corrected data; and the current and voltage signal acquisition and correction unit sends the asynchronously sampled data or the synchronously sampled data to the channel selection subunit after each sampling point is completed, and the asynchronously sampled data or the synchronously sampled data are both represented by three bytes;

the output point number processing subunit is configured for selecting a number of output points according to the number of sampling points output by the asynchronously sampled data or the synchronously sampled data every cycle to obtain the asynchronously sampled data or the synchronously sampled data after output point number processing; when $128 \leq N_{ADC1} < 256$, the number of output points is 128; and when $N_{ADC1} \geq 256$, the number of output points is 128 or 256;

the data framing processing subunit is configured for performing data framing processing on the asynchronously sampled data or the synchronously sampled data after output point number processing, and a waveform data format after processing is: frame header+U+IA+IB+checksum;

wherein,

the frame header is one byte;

U represents the corrected data of the voltage signal, U = U_Byte0 +U_Byte1 + U_Byte2, and U _Byte0 to U_Byte2 represent three byte representations of the corrected data of the voltage signal respectively;

Ia represents the corrected data of the live wire current signal, Ia = Ia_Byte0 + Ia_Byte1 + Ia _Byte2, and Ia _Byte0 to Ia_Byte2 represent three byte representations of the corrected data of the live wire current signal respectively;

Ib represents the corrected data of the zero wire current signal, Ib = Ib_Byte0 + Ib_Byte1 + Ib_Byte2, and Ib _Byte0 to Ib_Byte2 represent three byte representations of the corrected data of the zero wire current signal respectively;

U+Ia+Ib is adjusted according to a configuration of a sampled original data output control register; and

checksum is an inverse of an accumulated sum of the corrected data of the voltage signal and/or the corrected data of the current signal, plus 0x33.

A waveform is processed in the single-phase electric energy metering chip to meet a requirement of a next-generation Internet of Things intelligent electric energy meter for a transmission data format of waveform data, thus reducing resource expenditures of the main control chip of the management core module, the main control chip of the extension module 1 and the main control chip of the extension module 2.

In combination with the first aspect, optionally, the communication interface adopts UART (Universal Asynchronous Receiver/Transmitter) communication, and a Baud rate is adaptive within a range of 1200 bps to 19200 bps; and more than one energy output port is provided, energy data is output in a square wave mode, and a high level of a square wave lasts for 80 ms; and a type of the energy data output by the energy output port is capable of being configured through a CF (Calibration Frequency) pulse output control register.

In a second aspect, an intelligent Internet of Things meter based on an IR46 standard is disclosed, which comprises a metering core module, wherein the metering core module comprises the single-phase electric energy metering chip above and a metering main control chip, and an electrical isolation circuit with a withstand voltage strength of 4 KV is used between the single-phase electric energy metering chip and the metering main control chip; and

the metering core module is designed by combining the single-phase electric energy metering chip with a general main control chip, and a position of electrical isolation is between the single-phase electric energy metering chip and the metering main control chip, which not only makes the electrical isolation circuit more simple and reliable, but also reduces a cost.

Beneficial effects:

by adopting the metering core module designed by combining the single-phase electric energy metering chip based on the IR46 standard provided by the present application with the general main control chip, an isolation circuit design can be simplified to completely avoid contact between a human body and a power grid, so that higher safety is achieved, the problems of electrical isolation and reliable connection between modules are well solved, and the metering requirement of the next-generation intelligent Internet of Things electric energy meter can be fully met. Meanwhile, the single-phase electric energy metering chip can greatly simplify a design of the next-generation intelligent Internet of Things meter, and reduce development and production costs of the next-generation intelligent Internet of Things meter.

## BRIEF DESCRIPTION OF THE DRAWINGS

The present invention is further described in detail hereinafter with reference to the drawings and specific embodiments, and the advantages of the above and/or other aspects of the present invention will be clearer.

FIG. 1 is a first schematic structural diagram of a new-generation single-phase intelligent Internet of Things meter in the prior art.

FIG. 2 is a schematic diagram of assemblies of the new-generation single-phase intelligent Internet of Things meter in the prior art.

FIG. 3 is a second schematic structural diagram of the new-generation single-phase intelligent Internet of Things meter in the prior art.

FIG. 4 is a schematic diagram of an interface between a metering core module and a management core module in the prior art.

FIG. 5 is a schematic structural diagram of an intelligent Internet of Things meter based on an IR46 standard provided by an embodiment of the present application.

FIG. 6 is a schematic structural diagram of a single-phase electric energy metering chip based on an IR46 standard provided by the embodiment of the present application.

FIG. 7 is a schematic structural diagram of a current and voltage signal acquisition and correction unit in the single-phase electric energy metering chip based on the IR46 standard provided by the embodiment of the present application.

FIG. 8 is a schematic structural diagram of a harmonic measurement and metering unit in the single-phase electric energy metering chip based on the IR46 standard provided by the embodiment of the present application.

FIG. 9 is a schematic structural diagram of a terminal temperature measurement unit in the single-phase electric energy metering chip based on the IR46 standard provided by the embodiment of the present application.

FIG. 10 is a schematic structural diagram of an original waveform data processing unit in the single-phase electric energy metering chip based on the IR46 standard provided by the embodiment of the present application.

## DETAILED DESCRIPTION

Embodiments of the present invention are described hereinafter with reference to the drawings.

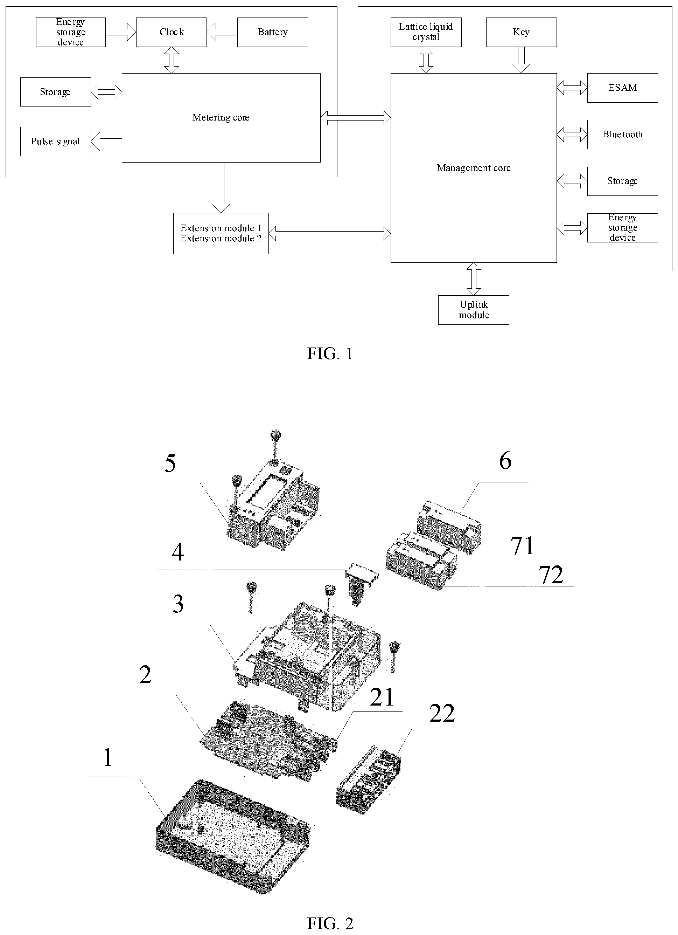

A new-generation single-phase intelligent Internet of Things meter adopts a multi-core modularization design concept, and realizes mutual independence between a legal metering function and other functions, and a functional block diagram and a schematic diagram of assemblies are shown in FIG. 1 and FIG. 2:

1. A new-generation intelligent electric energy meter is mainly composed of a metering core module, a management core module, function extension modules, an uplink module and other structural assemblies.

2. When mounted and used, the metering core module 2 is assembled with a bottom case 1 and an upper cover assembly 3 into a whole to be connected with a power line, and the management core module 5, the uplink module 6, the function extension modules 71 and 72, and a battery box assembly 4 may be hot-swapped and replaced if permitted. A wiring terminal 21 is an interface for connecting the intelligent electric energy meter with a power grid, and a terminal base 22 is a mounting wiring terminal for fixing the metering core module 2.

3. As a metering standard instrument, the metering core module cannot be replaced, and a program cannot be upgraded.

4. In order to ensure the safety of personnel, the metering core module and other functional modules must be subjected to electrical isolation.

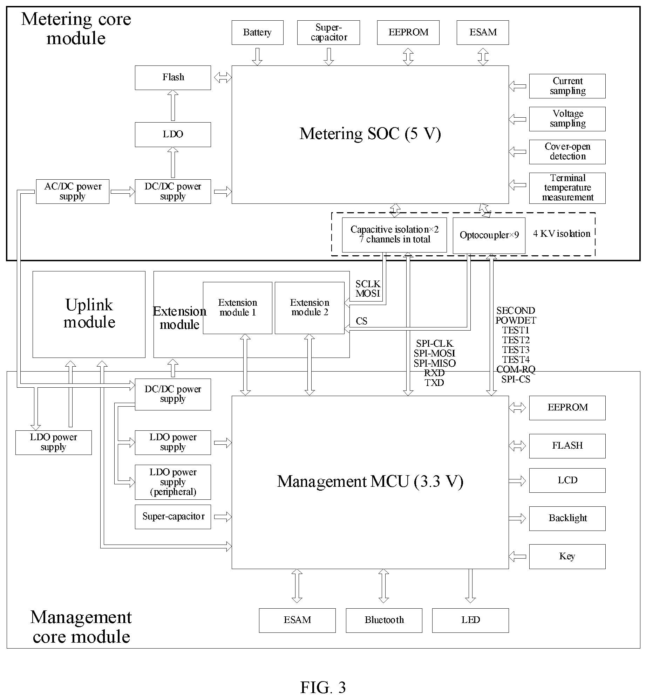

As mentioned earlier, because of having no single-phase metering chip that meets the requirements, the existing metering core module of the new-generation single-phase intelligent Internet of Things electric energy meter can only be implemented by an electric energy metering SoC chip, and the whole single-phase intelligent Internet of Things electric energy meter designed based on this solution is shown in FIG. 3:

1. The metering core module is designed into the SoC chip with peripherals such as a metering function, an MCU and an RTC (Real Time Clock).

2. Because the SoC solution is adopted, the whole metering core module is actually a high-voltage area to ensure a safe hot-swap requirement of the management core module. There is isolation with a withstand voltage strength of 4 KV between interfaces of the metering core module and the management core module.

3. Because current and voltage waveform data of the metering core module need to be transmitted to the function extension module, the isolation with the withstand voltage strength of 4 KV is also adopted between the metering core module and various function extension modules.

4. A battery is used to supply power to the RTC module of the metering core, and in order to realize hot-swap operation of the battery, it is necessary to make special treatment for a battery box and a contact point to prevent a human body from touching a high-voltage part.

The metering core module solution based on the SoC chip design as mentioned above has the following problems:

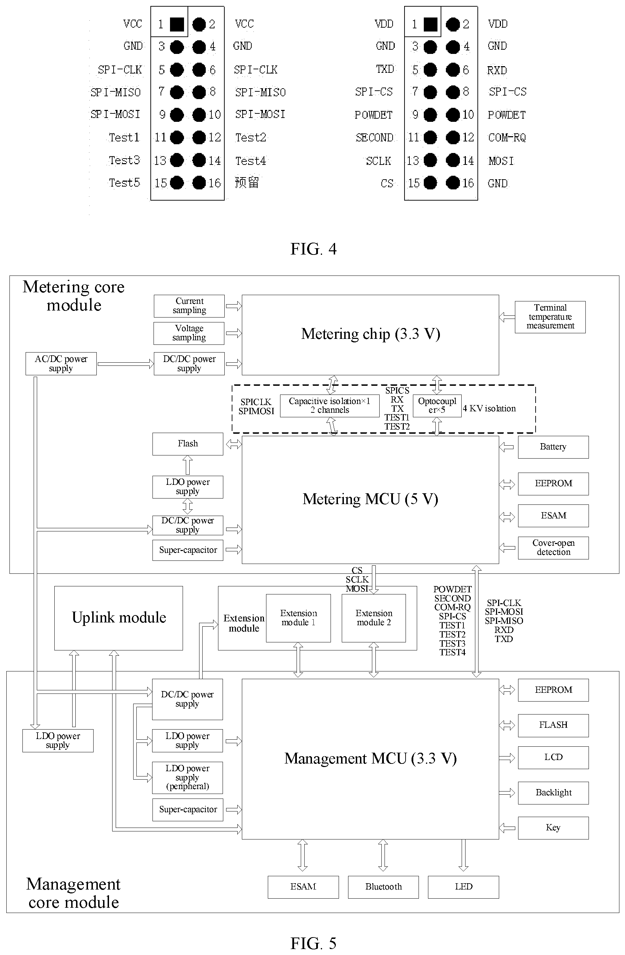

1. There are many interfaces with complicated functions between the metering core module and the management core module, as shown in FIG. 4: there are both an analog signal and a digital signal, and there are both a high-speed communication port and an ordinary logic level interface. Therefore, a circuit may be more complicated to realize the electrical isolation at the interfaces, thus increasing a design difficulty and a design cost.

2. There is frequent data exchange between the management core module and the metering core module, a communication rate of an SPI interface is required to reach 2 Mbps, and a communication rate of a serial port is required to reach 115200 bps. In the case of isolation, it is difficult to ensure the stability of communication at such a high communication rate. Especially in an extreme environment of high and low temperatures, it is more difficult to ensure the reliability of communication due to a temperature influence on an isolation device.

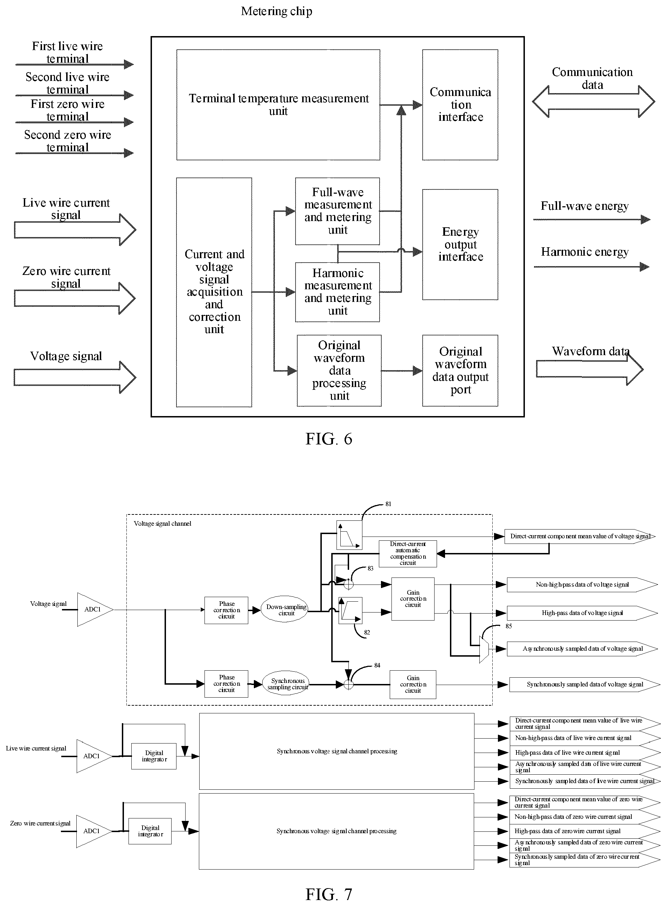

First Embodiment of the present application provides a single-phase electric energy metering chip based on an IR46 standard, which, as shown in FIG. 6, comprises a current and voltage signal acquisition and correction unit, a full-wave measurement and metering unit, a harmonic measurement and metering unit, an original sampled data processing unit, a terminal temperature measurement unit, a communication interface, an energy output interface and an original waveform data output port.

The current and voltage signal acquisition and correction unit is configured for performing analog-to-digital conversion on a voltage signal and a current signal, and performing phase and gain correction on the signals subjected to the analog-to-digital conversion to obtain corrected data of the voltage signal and corrected data of the current signal.

The full-wave measurement and metering unit is configured for calculating and obtaining full-wave data according to the corrected data of the voltage signal and the corrected data of the current signal, and the full-wave data comprises a full-wave effective value, full-wave power, a grid frequency, a power factor and full-wave energy data.

The harmonic measurement and metering unit is configured for calculating and obtaining harmonic data according to the corrected data of the voltage signal and the corrected data of the current signal, and the harmonic data comprises a harmonic effective value, harmonic power and harmonic energy data.

The original waveform data processing unit is configured for processing the corrected data of the voltage signal and/or the corrected data of the current signal to obtain waveform data.

The terminal temperature measurement unit comprises acquisition and correction of a temperature measurement signal, and is configured for measuring and monitoring temperatures of four wiring terminals of an electric energy meter to obtain terminal temperature measurement data.

The communication interface is configured for communicating with a metering main control chip, the metering main control chip controls the single-phase electric energy metering chip through the communication interface, and reads the full-wave data, and the harmonic data and the terminal temperature measurement data.

The energy output interface is configured for outputting the full-wave energy data and the harmonic energy data.

The original waveform data output port is configured for outputting the waveform data in an active output mode, which is generally an SPI (Serial Peripheral Interface) active mode.

As shown in FIG. 7, the current signal comprises a live wire current signal and a zero wire current signal, and the current and voltage signal acquisition and correction unit comprises a first acquisition and correction subunit, a second acquisition and correction subunit and a third acquisition and correction subunit.

The first acquisition and correction subunit comprises a first analog-to-digital converter ADC1 and a voltage signal channel, the first analog-to-digital converter ADC1 is configured for performing the analog-to-digital conversion on the voltage signal to obtain a voltage digital signal; and the voltage signal channel is configured for performing the phase and gain correction on the voltage digital signal to obtain the corrected data of the voltage signal.

The second acquisition and correction subunit and the third acquisition and correction subunit both comprise a first analog-to-digital converter ADC1, a digital integrator and a current signal channel, and the current signal channel and the voltage signal channel have the same structure.

The second acquisition and correction subunit is input with the live wire current signal and outputs corrected data of the live wire current signal; and the third acquisition and correction subunit is input with the zero wire current signal and outputs corrected data of the zero wire current signal.

The corrected data comprises a direct-current component mean value, non-high-pass data, high-pass data, asynchronously sampled data and synchronously sampled data of a corresponding signal, and the asynchronously sampled data and the synchronously sampled data are output in a DMA mode.

As shown in FIG. 7, the voltage signal channel comprises a metering correction circuit, and the metering correction circuit comprises a phase correction circuit, a down-sampling circuit, a low-pass filter 81, a high-pass filter 82, a direct-current automatic compensation circuit, a first arithmetic unit 83, a gain correction circuit and a first selector 85.

The phase correction circuit is configured for performing metering phase correction on the voltage digital signal to obtain metering-phase-corrected data.

The down-sampling circuit is configured for performing down-sampling on the metering-phase-corrected data to obtain down-sampled data.

The low-pass filter 81 is configured for performing low-pass filtration on the down-sampled data to obtain a direct-current component mean value of the voltage signal.

The direct-current automatic compensation circuit is configured for performing direct-current compensation on the direct-current component mean value of the voltage signal to obtain direct-current-compensated data; when the direct-current automatic compensation circuit is turned off, the direct-current-compensated data is zero; and the direct-current automatic compensation circuit may be controlled to be turned on and off by a direct-current compensation register.

The first arithmetic unit 83 is configured for subtracting the direct-current-compensated data from the down-sampled data to obtain a first arithmetic value.

The high-pass filter 82 is configured for performing high-pass filtration on the down-sampled data to obtain a second alternating-current component value.

The gain correction circuit is configured for performing metering gain correction on the first arithmetic value and the second alternating-current component value respectively, and after the first arithmetic value passes through the gain correction circuit, non-high-pass data of the voltage signal is obtained; and after the second alternating-current component value passes through the gain correction circuit, high-pass data of the voltage signal is obtained.

The first selector 85 is configured for selecting the non-high-pass data of the voltage signal or the high-pass data of the voltage signal to obtain asynchronously sampled data of the voltage signal. In practical application, for example, if direct-current metering needs to be performed or metering data needs to be obtained quickly, the non-high-pass data of the voltage signal may be selected in a scene with a low accuracy requirement; and the high-pass data of the voltage signal may be selected in a scene with a high accuracy requirement and a low response speed requirement.

As shown in FIG. 7, the voltage signal channel further comprises a waveform correction circuit, and the waveform correction circuit comprises a phase correction circuit, a synchronous sampling circuit, a second arithmetic unit 84 and a gain correction circuit.

The phase correction circuit is further configured for performing waveform phase correction on the voltage digital signal to obtain waveform-phase-corrected data.

The synchronous sampling circuit is configured for performing synchronous sampling on the waveform-phase-corrected data to obtain synchronously sampled data.

The second arithmetic unit 84 is configured for subtracting the direct-current-compensated data from the synchronously sampled data to obtain a third arithmetic value.

The gain correction circuit is further configured for performing waveform gain correction on the third arithmetic value to obtain synchronously sampled data of the voltage signal.

The harmonic effective value comprises M-order harmonic and total harmonic current and voltage effective values, the harmonic power comprises M-order harmonic and total harmonic active and reactive power, and the harmonic energy data comprises M-order harmonic and total harmonic active and reactive energy data; and M represents a total number of harmonic waves, and $1 \leq M \leq 41$. In the embodiment, according to requirements of intelligent Internet of Things, a value of M is 41.

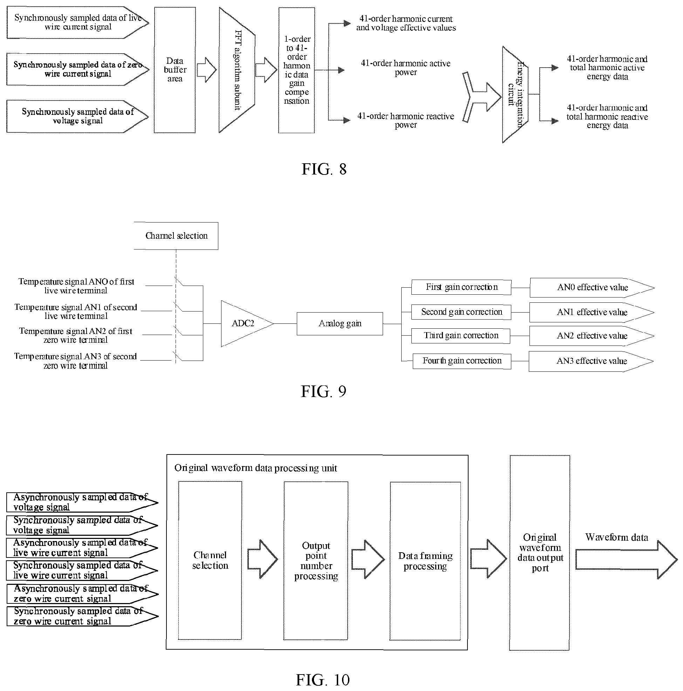

As shown in FIG. 8, the harmonic measurement and metering unit comprises an FFT algorithm subunit, a 1-order to M-order harmonic data gain compensation circuit and an energy integration circuit.

The synchronously sampled data of the voltage signal and synchronously sampled data of the current signal are put into a data buffer area inside the single-phase electric energy metering chip as data sources, and the FFT algorithm subunit performs harmonic operation on the synchronously sampled data of the voltage signal and the synchronously sampled data of the current signal every other period $T_{FFT}$ to obtain harmonic operation results. **In** the embodiment, a value of $T_{FFT}$ is 20 ms.

The 1-order to M-order harmonic data gain compensation circuit performs gain compensation on the harmonic operation results to obtain M-order harmonic current and voltage effective values, M-order harmonic active power and M-order harmonic reactive power respectively.

The energy integration circuit performs energy integration operation on the M-order harmonic active power and the M-order harmonic reactive power respectively, and after the M-order harmonic active power passes through the energy integration circuit, the M-order harmonic and total harmonic active energy data is obtained; and after the M-order harmonic reactive power passes through the energy integration circuit, the M-order harmonic and total harmonic reactive energy data is obtained.

As shown in FIG. 9, the terminal temperature measurement unit comprises a channel selection subunit, a second analog-to-digital converter ADC2, an analog gain circuit and first to fourth gain correction circuits.

The channel selection subunit is configured for selecting a temperature signal from a temperature signal AN0 of a first live wire terminal, a temperature signal AN1 of a second live wire terminal, a temperature signal AN2 of a first zero wire terminal and a temperature signal AN3 of a second zero wire terminal to enter the second analog-to-digital converter ADC2; and a user may select a channel to the second analog-to-digital converter through the control register in a time-sharing multiplexing mode, or make the second analog-to-digital converter automatically switch between AN0 and AN3 channels.

The second analog-to-digital converter ADC2 is configured for performing analog-to-digital conversion on the terminal temperature signal to obtain a terminal temperature digital signal.

The analog gain circuit is configured for obtaining a terminal temperature gain value from the terminal temperature digital signal.

The first to fourth gain correction circuits are configured for performing gain correction on a first live wire terminal temperature gain value, a second live wire terminal temperature gain value, a first zero wire terminal temperature gain value and a second zero wire terminal temperature gain value respectively to obtain corresponding temperature effective values. Each channel outputs a corresponding effective value, and a refresh cycle of the effective value is 1 second.

A number of sampling points of each cycle of the first analog-to-digital converter ADC1 is $N_{ADC1}$, $N_{ADC1} \geq 128$, and accuracy of the first analog-to-digital converter ADC1 is 22 bits, so that the corrected data of the voltage signal and the corrected data of the current signal are 22 bits.

As shown in FIG. 10, the original waveform data processing unit comprises a channel selection subunit, an output point number processing subunit and a data framing processing subunit.

The channel selection subunit is configured for selecting the waveform data to output the corrected data of the voltage signal and/or the corrected data of the current signal, and selecting the asynchronously sampled data or the synchronously sampled data in the corrected data; the current and voltage signal acquisition and correction unit sends the asynchronously sampled data or the synchronously sampled data to the channel selection subunit after each sampling point is completed, and the asynchronously sampled data or the synchronously sampled data are both represented by three bytes; and a circuit of the channel selection subunit may be realized by the register and the selector.

The output point number processing subunit is configured for selecting a number of output points according to the number of sampling points output by the asynchronously sampled data or the synchronously sampled data every cycle to obtain the asynchronously sampled data or the synchronously sampled data after output point number processing; when $128 \leq N_{ADC1} < 256$, the number of output points is 128; and when $N_{ADC1} \geq 256$, the number of output points is 128 or 256.

The data framing processing subunit is configured for performing data framing processing on the asynchronously sampled data or the synchronously sampled data after output point number processing, and a waveform data format after processing is: frame header+U+IA+IB+checksum; wherein,

the frame header is one byte, this byte is filled in by the user: the single-phase electric energy metering chip reserves one register for the user to write the frame header to be sent, such as writing 0x7D by the user;

U represents the corrected data of the voltage signal, U = U _Byte0 +U_Byte1 + U_Byte2, and U _Byte0 to U _Byte2 represent three byte representations of the corrected data of the voltage signal respectively;

Ia represents the corrected data of the live wire current signal, Ia = Ia _Byte0 + Ia_Byte1 + Ia_Byte2, and Ia _Byte0 to Ia_Byte2 represent three byte representations of the corrected data of the live wire current signal respectively;

Ib represents the corrected data of the zero wire current signal, Ib = Ib _Byte0 + Ib_Byte1 + Ib_Byte2, and Ib _Byte0 to Ib_Byte2 represent three byte representations of the corrected data of the zero wire current signal respectively;

U+Ia+Ib is adjusted according to a configuration of a sampled original data output control register; and

checksum is an inverse of an accumulated sum of the corrected data of the voltage signal and/or the corrected data of the current signal, plus 0x33.

If the waveform data selects to output the corrected data of the voltage signal, which means that only a transmission U channel is selected, then checksum=0x33 + ~(U_Byte0 + U_Byte1 + U_Byte2); and if the waveform data selects to output the corrected data of the voltage signal and the corrected data of the live wire current signal (sampled data of U and Ia are selected to be sent simultaneously), then checksum=0x33 + ~(U_Byte0 + U_Byte1 + U_Byte2+Ia _Byte0 + Ia_Byte1 + Ia_Byte2).

If the waveform data selects to output the corrected data of the voltage signal and the corrected data of the live wire current signal, then every time the single-phase electric energy metering chip completes sampling, a waveform data format sent is as follows:

$$0x7d+ U\_Byte0+ U\_Byte1+ U\_Byte2+ Ia\_Byte0+ Ia\_Byte1+ Ia\_Byte2+checksum$$

The communication interface adopts UART communication, and a Baud rate is adaptive within a range of 1200 bps to 19200 bps.

More than one energy output port is provided, energy data is output in a square wave mode, and a high level of a square wave lasts for 80 ms; and a type of the energy data output by the energy output port is capable of being configured through a CF pulse output control register. In the embodiment, considering a size and a number of pins of the chip and requirements of the Internet of Things meter, two energy output ports are provided.

Second Embodiment of the present application provides an intelligent Internet of Things meter based on an IR46 standard, which, as shown in FIG. 5, comprises a metering core module, wherein the metering core module comprises the single-phase electric energy metering chip according to any one of claims 1 to 9 and a metering main control chip, and an electrical isolation circuit with a withstand voltage strength of 4 KV is used between the single-phase electric energy metering chip and the metering main control chip.

The circuits not described in detail in the embodiment of the present invention or the circuits corresponding to the subunits are all obtained by the prior art known to those skilled in the art, which will not be limited herein.

The present invention provides the idea and method of the single-phase electric energy metering chip and intelligent Internet of Things meter based on the IR46 standard. There are many methods and ways to realize the technical solutions, and the above is only the specific embodiments of the present invention. It should be pointed out that, for those of ordinary skills in the art, several improvements may be made without departing from the principle of the present invention as defined by the appended Claims.

## Claims

1. A single-phase electric energy metering chip based on an IR46 standard, comprising a current and voltage signal acquisition and correction unit, a full-wave measurement and metering unit, a harmonic measurement and metering unit, an original sampled data processing unit, a terminal temperature measurement unit, a communication interface, an energy output interface and an original waveform data output port, wherein,

the current and voltage signal acquisition and correction unit is configured for performing analog-to-digital conversion on a voltage signal and a current signal, and performing phase and gain correction on the signals subjected to the analog-to-digital conversion to obtain corrected data of the voltage signal and corrected data of the current signal;

the corrected data comprises a direct-current component mean value, non-high-pass data, high-pass data, asynchronously sampled data and synchronously sampled data of a corresponding signal, and the asynchronously sampled data and the synchronously sampled data are output in a DMA mode;

the full-wave measurement and metering unit is configured for calculating and obtaining full-wave data according to the corrected data of the voltage signal and the corrected data of the current signal, and the full-wave data comprises a full-wave effective value, full-wave power, a grid frequency, a power factor and full-wave energy data;

the harmonic measurement and metering unit is configured for calculating and obtaining harmonic data according to the corrected data of the voltage signal and the corrected data of the current signal, and the harmonic data comprises a harmonic effective value, harmonic power and harmonic energy data;

the original waveform data processing unit is configured for processing the corrected data of the voltage signal and/or the corrected data of the current signal to obtain waveform data;

the terminal temperature measurement unit comprises acquisition and correction of a temperature measurement signal, and is configured for measuring and monitoring temperatures of four wiring terminals of an electric energy meter to obtain terminal temperature measurement data;

the communication interface is configured for communicating with a metering main control chip, and the metering main control chip controls the single-phase electric energy metering chip through the communication interface, and reads the full-wave data, the harmonic data and the terminal temperature measurement data;

the energy output interface is configured for outputting the full-wave energy data and the harmonic energy data; and

the original waveform data output port is configured for outputting the waveform data in an active output mode;

the current and voltage signal acquisition and correction unit comprises a first acquisition and correction subunit, the first acquisition and correction subunit comprises a first analog-to-digital converter and a voltage signal channel, the first analog-to-digital converter is configured for performing the analog-to-digital conversion on the voltage signal to obtain a voltage digital signal; and the voltage signal channel is configured for performing the phase and gain correction on the voltage digital signal to obtain the corrected data of the voltage signal;
the voltage signal channel comprises a metering correction circuit, and the metering correction circuit comprises a phase correction circuit, a down-sampling circuit, a low-pass filter (81), a high-pass filter (82), a direct-current automatic compensation circuit, a first arithmetic unit (83), a gain correction circuit and a first selector (85),
the phase correction circuit is configured for performing metering phase correction on the voltage digital signal to obtain metering-phase-corrected data;
the down-sampling circuit is configured for performing down-sampling on the metering-phase-corrected data to obtain down-sampled data;
the low-pass filter (81) is configured for performing low-pass filtration on the down-sampled data to obtain a direct-current component mean value of the voltage signal;
the direct-current automatic compensation circuit is configured for performing direct-current compensation on the direct-current component mean value of the voltage signal to obtain direct-current-compensated data; and when the direct-current automatic compensation circuit is turned off, the direct-current-compensated data is zero;
the first arithmetic unit (83) is configured for subtracting the direct-current-compensated data from the down-sampled data to obtain a first arithmetic value;
the high-pass filter (82) is configured for performing high-pass filtration on the down-sampled data to obtain a second alternating-current component value;
the gain correction circuit is configured for performing metering gain correction on the first arithmetic value and the second alternating-current component value respectively, and after the first arithmetic value passes through the gain correction circuit, non-high-pass data of the voltage signal is obtained; and after the second alternating-current component value passes through the gain correction circuit, high-pass data of the voltage signal is obtained; and
the first selector (85) is configured for selecting the non-high-pass data of the voltage signal or the high-pass data of the voltage signal to obtain asynchronously sampled data of the voltage signal.

2. The single-phase electric energy metering chip based on the IR46 standard according to claim 1, wherein the current signal comprises a live wire current signal and a zero wire current signal, and the current and voltage signal acquisition and correction unit also comprises a second acquisition and correction subunit and a third acquisition and correction subunit,

the second acquisition and correction subunit and the third acquisition and correction subunit both comprise a first analog-to-digital converter, a digital integrator and a current signal channel, and the current signal channel and the voltage signal channel have the same structure;
the second acquisition and correction subunit is input with the live wire current signal and outputs corrected data of the live wire current signal; and the third acquisition and correction subunit is input with the zero wire current signal and outputs corrected data of the zero wire current signal.

3. The single-phase electric energy metering chip based on the IR46 standard according to claim 2, wherein the voltage signal channel further comprises a waveform correction circuit, and the waveform correction circuit comprises a phase correction circuit, a synchronous sampling circuit, a second arithmetic unit (84) and a gain correction circuit,

the phase correction circuit is further configured for performing waveform phase correction on the voltage digital signal to obtain waveform-phase-corrected data;
the synchronous sampling circuit is configured for performing synchronous sampling on the waveform-phase-corrected data to obtain synchronously sampled data;
the second arithmetic unit (84) is configured for subtracting the direct-current-compensated data from the synchronously sampled data to obtain a third arithmetic value; and
the gain correction circuit is further configured for performing waveform gain correction on the third arithmetic value to obtain synchronously sampled data of the voltage signal.

4. The single-phase electric energy metering chip based on the IR46 standard according to claim 3, wherein the harmonic effective value comprises M-order harmonic and total harmonic current and voltage effective values, the harmonic power comprises M-order harmonic and total harmonic active and reactive power, and the harmonic energy data comprises M-order harmonic and total harmonic active and reactive energy data; and M represents a total number of harmonic waves, and $1 \leq M \leq 41$;

the harmonic measurement and metering unit comprises an FFT algorithm subunit, a 1-order to M-order harmonic data gain compensation circuit and an energy integration circuit,

the synchronously sampled data of the voltage signal and synchronously sampled data of the current signal are put into a data buffer area inside the single-phase electric energy metering chip as data sources, and the FFT algorithm subunit performs harmonic operation on the synchronously sampled data of the voltage signal and the synchronously sampled data of the current signal every other period $T_{FFT}$ to obtain harmonic operation results; the 1-order to M-order harmonic data gain compensation circuit performs gain compensation on the harmonic operation results to obtain M-order harmonic current and voltage effective values, M-order harmonic active power and M-order harmonic reactive power respectively; and

the energy integration circuit performs energy integration operation on the M-order harmonic active power and the M-order harmonic reactive power respectively, and after the M-order harmonic active power passes through the energy integration circuit, the M-order harmonic and total harmonic active energy data is obtained; and after the M-order harmonic reactive power passes through the energy integration circuit, the M-order harmonic and total harmonic reactive energy data is obtained.

5. The single-phase electric energy metering chip based on the IR46 standard according to claim 4, wherein the terminal temperature measurement unit comprises a channel selection subunit, a second analog-to-digital converter, an analog gain circuit and first to fourth gain correction circuits,

the channel selection subunit is configured for selecting a terminal temperature signal from a first live wire terminal, a second live wire terminal, a first zero wire terminal and a second zero wire terminal to enter the second analog-to-digital converter;

the second analog-to-digital converter is configured for performing analog-to-digital conversion on the terminal temperature signal to obtain a terminal temperature digital signal;

the analog gain circuit is configured for obtaining a terminal temperature gain value from the terminal temperature digital signal; and

the first to fourth gain correction circuits are configured for performing gain correction on a first live wire terminal temperature gain value, a second live wire terminal temperature gain value, a first zero wire terminal temperature gain value and a second zero wire terminal temperature gain value respectively to obtain corresponding temperature effective values.

6. The single-phase electric energy metering chip based on the IR46 standard according to claim 5, wherein a number of sampling points of each cycle of the first analog-to-digital converter is $N_{ADC1}$, $N_{ADC1} \geq 128$, and accuracy of the first analog-to-digital converter is 22 bits, so that the corrected data of the voltage signal and the corrected data of the current signal are 22 bits.

7. The single-phase electric energy metering chip based on the IR46 standard according to claim 6, wherein the original waveform data processing unit comprises a channel selection subunit, an output point number processing subunit and a data framing processing subunit,

the channel selection subunit is configured for selecting the waveform data to output the corrected data of the voltage signal and/or the corrected data of the current signal, and selecting the asynchronously sampled data or the synchronously sampled data in the corrected data; and the current and voltage signal acquisition and correction unit sends the asynchronously sampled data or the synchronously sampled data to the channel selection subunit after each sampling point is completed, and the asynchronously sampled data or the synchronously sampled data are both represented by three bytes;

the output point number processing subunit is configured for selecting a number of output points according to the number of sampling points output by the asynchronously sampled data or the synchronously sampled data every cycle to obtain the asynchronously sampled data or the synchronously sampled data after output point number processing; when $128 \leq N_{ADC1} < 256$, the number of output points is 128; and when $N_{ADC1} \geq 256$, the number of output points is 128 or 256;

the data framing processing subunit is configured for performing data framing processing on the asynchronously sampled data or the synchronously sampled data after output point number processing, and a waveform data format after processing is: frame header+U+IA+IB+checksum;

wherein,

the frame header is one byte;

U represents the corrected data of the voltage signal, U = U _Byte0 +U_Byte1 + U_Byte2, and U _Byte0 to U _Byte2 represent three byte representations of the corrected data of the voltage signal respectively;

Ia represents the corrected data of the live wire current signal, Ia = Ia _Byte0 + Ia_Byte1 + Ia _Byte2, and Ia _Byte0 to Ia_Byte2 represent three byte representations of the corrected data of the live wire current signal respectively;

Ib represents the corrected data of the zero wire current signal, Ib = Ib_Byte0 + Ib_Byte1 + Ib_Byte2, and Ib_Byte0 to Ib_Byte2 represent three byte representations of the corrected data of the zero wire current signal respectively; U+Ia+Ib is adjusted according to a configuration of a sampled original data output control register; and checksum is an inverse of an accumulated sum of the corrected data of the voltage signal and/or the corrected data of the current signal, plus 0x33.

8. The single-phase electric energy metering chip based on the IR46 standard according to claim 7, wherein the communication interface adopts UART communication, and a Baud rate is adaptive within a range of 1200 bps to 19200 bps; and
more than one energy output port is provided, energy data is output in a square wave mode, and a high level of a square wave lasts for 80 ms; and a type of the energy data output by the energy output port is capable of being configured through a CF pulse output control register.

9. An intelligent Internet of Things meter based on an IR46 standard, comprising a metering core module, wherein the metering core module comprises the single-phase electric energy metering chip according to any one of claims 1 to 8 and a metering main control chip, and an electrical isolation circuit with a withstand voltage strength of 4 KV is used between the single-phase electric energy metering chip and the metering main control chip.

**Patentansprüche**

1. Einphasen-Zählchip für elektrische Energie, basierend auf einem IR46-Standard, umfassend eine Strom- und Spannungssignalerfassungs- und -korrektureinheit, eine Ganzwellenmess- und -zähleinheit, eine Oberschwingungsmess- und -zähleinheit, eine Originalabtastdatenverarbeitungseinheit, eine Klemmentemperaturmesseinheit, eine Kommunikationsschnittstelle, eine Energieausgabeschnittstelle und einen Originalwellenformdatenausgabeanschluss, wobei

die Strom- und Spannungssignalerfassungs- und -korrektureinheit dazu konfiguriert ist, eine Analog-Digital-Wandlung an einem Spannungssignal und einem Stromsignal durchzuführen und eine Phasen- und Verstärkungskorrektur an den Signalen durchzuführen, die der Analog-Digital-Wandlung unterzogen wurden, um korrigierte Daten des Spannungssignals und korrigierte Daten des Stromsignals zu erhalten;
die korrigierten Daten einen Gleichstromkomponentenmittelwert, Nicht-Hochpassdaten, Hochpassdaten, asynchron abgetastete Daten und synchron abgetastete Daten eines entsprechenden Signals umfassen und die asynchron abgetasteten Daten und die synchron abgetasteten Daten in einem DMA-Modus ausgegeben werden;
die Ganzwellenmess- und -zähleinheit zum Berechnen und Erhalten von Ganzwellendaten gemäß den korrigierten Daten des Spannungssignals und den korrigierten Daten des Stromsignals konfiguriert ist und die Ganzwellendaten einen Ganzwelleneffektivwert, eine Ganzwellenleistung, eine Netzfrequenz, einen Leistungsfaktor und Ganzwellenenergiedaten umfassen;
die Oberschwingungsmess- und -zähleinheit zum Berechnen und Erhalten von Oberschwingungsdaten gemäß den korrigierten Daten des Spannungssignals und den korrigierten Daten des Stromsignals konfiguriert ist und die Oberschwingungsdaten einen Oberschwingungseffektivwert, Oberschwingungsleistung und Oberschwingungsenergiedaten umfassen;
die Originalwellenformdatenverarbeitungseinheit zum Verarbeiten der korrigierten Daten des Spannungssignals und/oder der korrigierten Daten des Stromsignals konfiguriert ist, um Wellenformdaten zu erhalten;
die Klemmentemperaturmesseinheit die Erfassung und Korrektur eines Temperaturmesssignals umfasst und zum Messen und Überwachen von Temperaturen von vier Leitungsklemmen eines Zählers für elektrische Energie konfiguriert ist, um Klemmentemperaturmessdaten zu erhalten;
die Kommunikationsschnittstelle zum Kommunizieren mit einem Zählhauptsteuerchip konfiguriert ist und der Zählhauptsteuerchip den Einphasen-Zählchip für elektrische Energie über die Kommunikationsschnittstelle steuert und die Ganzwellendaten, die Oberschwingungsdaten und die Klemmentemperaturmessdaten liest;
die Energieausgabeschnittstelle zum Ausgeben der Ganzwellenenergiedaten und der Oberschwingungsenergiedaten konfiguriert ist; und
der Originalwellenformdatenausgabeanschluss zum Ausgeben der Wellenformdaten in einem aktiven Ausgabemodus konfiguriert ist;
die Strom- und Spannungssignalerfassungs- und -korrektureinheit eine erste Erfassungs- und Korrekturuntereinheit umfasst,
die erste Erfassungs- und Korrekturuntereinheit einen ersten Analog-Digital-Wandler und einen Spannungssignalkanal umfasst, der erste Analog-Digital-Wandler zum Durchführen der Analog-Digital-Wandlung an dem Spannungssignal konfiguriert ist, um ein digitales Spannungssignal zu erhalten; und der Spannungssignalkanal zum Durchführen der Phasen- und Verstärkungskorrektur an dem digitalen Spannungssignal konfiguriert ist, um die korrigierten Daten des Spannungssignals zu erhalten;

der Spannungssignalkanal eine Zählerkorrekturschaltung umfasst und die Zählerkorrekturschaltung eine Phasenkorrekturschaltung, eine Downsampling-Schaltung, einen Tiefpassfilter (81), einen Hochpassfilter (82), eine automatische Gleichstromkompensationsschaltung, eine erste Arithmetikeinheit (83), eine Verstärkungskorrekturschaltung und einen ersten Selektor (85) umfasst,

die Phasenkorrekturschaltung zum Durchführen einer Zählphasenkorrektur an dem digitalen Spannungssignal konfiguriert ist, um zählphasenkorrigierte Daten zu erhalten;

die Downsampling-Schaltung zum Durchführen eines Downsamplings an den zählphasenkorrigierten Daten konfiguriert ist, um downgesampelte Daten zu erhalten;

der Tiefpassfilter (81) zum Durchführen einer Tiefpassfilterung an den downgesampelten Daten konfiguriert ist, um einen Gleichstromkomponentenmittelwert des Spannungssignals zu erhalten;

die automatische Gleichstromkompensationsschaltung zum Durchführen einer Gleichstromkompensation an dem Gleichstromkomponentenmittelwert des Spannungssignals konfiguriert ist, um gleichstromkompensierte Daten zu erhalten; und wenn die automatische Gleichstromkompensationsschaltung ausgeschaltet ist, die gleichstromkompensierten Daten Null sind;

die erste Arithmetikeinheit (83) zum Subtrahieren der gleichstromkompensierten Daten von den downgesampelten Daten konfiguriert ist, um einen ersten arithmetischen Wert zu erhalten;

der Hochpassfilter (82) zum Durchführen einer Hochpassfilterung an den downgesampelten Daten konfiguriert ist, um einen zweiten Wechselstromkomponentenwert zu erhalten;

die Verstärkungskorrekturschaltung zum Durchführen einer Zählverstärkungskorrektur an dem ersten arithmetischen Wert beziehungsweise dem zweiten Wechselstromkomponentenwert konfiguriert ist und, nachdem der erste arithmetische Wert die Verstärkungskorrekturschaltung durchlaufen hat, Nicht-Hochpassdaten des Spannungssignals erhalten werden; und nachdem der zweite Wechselstromkomponentenwert die Verstärkungskorrekturschaltung durchlaufen hat, Hochpassdaten des Spannungssignals erhalten werden; und

der erste Selektor (85) zum Auswählen der Nicht-Hochpassdaten des Spannungssignals oder der Hochpassdaten des Spannungssignals konfiguriert ist, um asynchron abgetastete Daten des Spannungssignals zu erhalten.

2. Einphasen-Zählchip für elektrische Energie, basierend auf dem IR46-Standard, nach Anspruch 1, wobei das Stromsignal ein Leiterstromsignal und ein Nullleiterstromsignal umfasst und die Strom- und Spannungssignalerfassungs- und -korrektureinheit außerdem eine zweite Erfassungs- und Korrektureinheit und eine dritte Erfassungs- und Korrekturuntereinheit umfasst,

die zweite Erfassungs- und Korrekturuntereinheit und die dritte Erfassungs- und Korrekturuntereinheit beide einen ersten Analog-Digital-Wandler, einen digitalen Integrator und einen Stromsignalkanal umfassen und der Stromsignalkanal und der Spannungssignalkanal die gleiche Struktur aufweisen;

in die zweite Erfassungs- und Korrekturuntereinheit das Leiterstromsignal eingegeben wird und es korrigierte Daten des Leiterstromsignals ausgibt; und in die dritte Erfassungs- und Korrekturuntereinheit das Nullleiterstromsignal eingegeben wird und es korrigierte Daten des Nullleiterstromsignals ausgibt.

3. Einphasen-Zählchip für elektrische Energie, basierend auf dem IR46-Standard, nach Anspruch 2, wobei der Spannungssignalkanal ferner eine Wellenformkorrekturschaltung umfasst und die Wellenformkorrekturschaltung eine Phasenkorrekturschaltung, eine Synchronabtastschaltung, eine zweite Arithmetikeinheit (84) und eine Verstärkungskorrekturschaltung umfasst,

die Phasenkorrekturschaltung ferner zum Durchführen einer Wellenformphasenkorrektur an dem digitalen Spannungssignal konfiguriert ist, um wellenformphasenkorrigierte Daten zu erhalten;

die Synchronabtastschaltung zum Durchführen eines synchronen Abtastens an den wellenformphasenkorrigierten Daten konfiguriert ist, um synchron abgetastete Daten zu erhalten;

die zweite Arithmetikeinheit (84) zum Subtrahieren der gleichstromkompensierten Daten von den synchron abgetasteten Daten konfiguriert ist, um einen dritten arithmetischen Wert zu erhalten; und

die Verstärkungskorrekturschaltung ferner zum Durchführen einer Wellenformverstärkungskorrektur an dem dritten arithmetischen Wert konfiguriert ist, um synchron abgetastete Daten des Spannungssignals zu erhalten.

4. Einphasen-Zählchip für elektrische Energie, basierend auf dem IR46-Standard, nach Anspruch 3, wobei der Oberschwingungseffektivwert M-Ordnungs- und Gesamtoberschwingungsstrom- und spannungseffektivwerte umfasst, die Oberschwingungsleistung M-Ordnungs-Oberschwingungs- und Gesamtoberschwingungswirk- und -blindleistung umfasst und die Oberschwingungsenergiedaten M-Ordnungs-Oberschwingungs- und Gesamtoberschwingungswirk- und -blindenergiedaten umfassen; und M eine Gesamtzahl von Oberschwingungswellen darstellt und $1 \leq M \leq 41$;

die Oberschwingungsmess- und -zähleinheit eine FFT-Algorithmus-Untereinheit, eine Oberschwingungsverstärkungskompensationsschaltung der Ordnung 1 bis M und eine Energieintegrationsschaltung umfasst,

die synchron abgetasteten Daten des Spannungssignals und die synchron abgetasteten Daten des Stromsignals als Datenquellen in einen Datenpufferbereich innerhalb des Einphasen-Zählchip für elektrische Energie hineingegeben werden und die FFT-Algorithmus-Untereinheit eine harmonische Operation an den synchron abgetasteten Daten des Spannungssignals und den synchron abgetasteten Daten des Stromsignals jede zweite Periode $T_{FFT}$ durchführt, um Ergebnisse der harmonischen Operation zu erhalten;

die Oberschwingungsverstärkungskompensationsschaltung der Ordnung 1 bis M eine Verstärkungskompensation an den Ergebnissen der harmonischen Operation durchführt, um M-Ordnungs-Oberschwingungsstrom- und -spannungseffektivwerte, M-Ordnungs-Oberschwingungswirkleistung beziehungsweise M-Ordnungs-Oberschwingungsblindleistung zu erhalten; und

die Energieintegrationsschaltung eine Energieintegrationsoperation an der M-Ordnungs-Oberschwingungswirkleistung beziehungsweise der M-Ordnungs-Oberschwingungsblindleistung durchführt und nachdem die M-Ordnungs-Oberschwingungswirkleistung die Energieintegrationsschaltung durchlaufen hat, die M-Ordnungs-Oberschwingungs- und Gesamtoberschwingungswirkenergiedaten erhalten werden; und nachdem die M-Ordnungs-Oberschwingungsblindleistung die Energieintegrationsschaltung durchlaufen hat, die M-Ordnungs-Oberschwingungs- und Gesamtoberschwingungsblindenergiedaten erhalten werden.

5. Einphasen-Zählchip für elektrische Energie, basierend auf dem IR46-Standard, nach Anspruch 4, wobei die Klemmentemperaturmesseinheit eine Kanalauswahl-Untereinheit, einen zweiten Analog-Digital-Wandler, eine Analogverstärkungsschaltung und erste bis vierte Verstärkungskorrekturschaltungen umfasst,

die Kanalauswahl-Untereinheit zum Auswählen eines Klemmentemperatursignals von einer ersten Leiterklemme, einer zweiten Leiterklemme, einer ersten Nullleiterklemme und einer zweiten Nullleiterklemme konfiguriert ist, die in den zweiten Analog-Digital-Wandler hineinzugeben sind;

der zweite Analog-Digital-Wandler zum Durchführen einer Analog-Digital-Wandlung an dem Klemmentemperatursignal konfiguriert ist, um ein digitales Klemmentemperatursignal zu erhalten;

die Analogverstärkungsschaltung zum Erhalten eines Klemmentemperaturverstärkungswerts aus dem digitalen Klemmentemperatursignal konfiguriert ist; und

die erste bis vierte Verstärkungskorrekturschaltung zum Durchführen einer Verstärkungskorrektur an einem ersten Leiterklemmentemperaturverstärkungswert, einem zweiten Leiterklemmentemperaturverstärkungswert, einem ersten Nullleiterklemmentemperaturverstärkungswert beziehungsweise einem zweiten Nullleiterklemmentemperaturverstärkungswert konfiguriert sind, um entsprechende Temperatureffektivwerte zu erhalten.

6. Einphasen-Zählchip für elektrische Energie, basierend auf dem IR46-Standard, nach Anspruch 5, wobei eine Anzahl von Abtastpunkten jedes Zyklus des ersten Analog-Digital-Wandlers $N_{ADC1}$, $N_{ADC1} \geq 128$, beträgt und eine Genauigkeit des ersten Analog-Digital-Wandlers 22 Bit beträgt, sodass die korrigierten Daten des Spannungssignals und die korrigierten Daten des Stromsignals 22 Bit betragen.

7. Einphasen-Zählchip für elektrische Energie, basierend auf dem IR46-Standard, nach Anspruch 6, wobei die Originalwellenformdatenverarbeitungseinheit eine Kanalauswahl-Untereinheit, eine Ausgabepunktanzahl-Verarbeitungsuntereinheit und eine Daten-Framing-Verarbeitungsuntereinheit umfasst,

die Kanalauswahl-Untereinheit zum Auswählen der Wellenformdaten, um die korrigierten Daten des Spannungssignals und/oder die korrigierten Daten des Stromsignals auszugeben, und Auswählen der asynchron abgetasteten Daten oder der synchron abgetasteten Daten in den korrigierten Daten konfiguriert ist; und die Strom- und Spannungssignalerfassungs- und - korrektureinheit die asynchron abgetasteten Daten oder die synchron abgetasteten Daten, nachdem jeder Abtastpunkt abgeschlossen ist, an die Kanalauswahl-Untereinheit sendet und die asynchron abgetasteten Daten oder die synchron abgetasteten Daten beide durch drei Bytes dargestellt werden;

die Ausgabepunktanzahl-Verarbeitungsuntereinheit zum Auswählen einer Anzahl von Ausgabepunkten gemäß der Anzahl von Abtastpunkten, die durch die asynchron abgetasteten Daten oder die synchron abgetasteten Daten in jedem Zyklus ausgegeben werden, konfiguriert ist, um die asynchron abgetasteten Daten oder die synchron abgetasteten Daten nach der Ausgabepunktanzahl-Verarbeitung zu erhalten; wobei, wenn $128 \leq N_{ADC1} < 256$, die Anzahl der Ausgabepunkte 128 beträgt; und wenn $N_{ADC1} \geq 256$, die Anzahl der Ausgabepunkte 128 oder 256 beträgt;

die Daten-Framing-Verarbeitungsuntereinheit zum Durchführen einer Daten-Framing-Verarbeitung an den asynchron abgetasteten Daten oder den synchron abgetasteten Daten nach der Ausgabepunktanzahl-Verarbeitung konfiguriert ist und ein Wellenformdatenformat nach der Verarbeitung Folgendes ist: Frame-Header+U+IA+IB+Prüfsumme ist;

wobei

der Frame-Header ein Byte ist;

U die korrigierten Daten des Spannungssignals darstellt, U = U_Byte0 +U_Byte1 + U _Byte2 und U_Byte0 bis U _Byte2 jeweils Drei-Byte-Darstellungen der korrigierten Daten des Spannungssignals darstellen;

Ia die korrigierten Daten des Leiterstromsignals darstellt, Ia = Ia_Byte0 + Ia_Byte1 + Ia_Byte2, und Ia_Byte0 bis Ia_Byte2 jeweils Drei-Byte-Darstellungen der korrigierten Daten des Leiterstromsignals darstellen;

Ib die korrigierten Daten des Nullleiterstromsignals darstellt, Ib = Ib_Byte0 + Ib_Byte1 + Ib_Byte2 und Ib_Byte0 bis Ib_Byte2 jeweils Drei-Byte-Darstellungen der korrigierten Daten des Nullleiterstromsignals darstellen;

U+Ia+Ib gemäß einer Konfiguration eines abgetasteten Originaldatenausgabesteuerregisters angepasst wird; und

Prüfsumme eine Inverse einer akkumulierten Summe der korrigierten Daten des Spannungssignals und/oder der korrigierten Daten des Stromsignals ist, plus 0x33.

8. Einphasen-Zählchip für elektrische Energie, basierend auf dem IR46-Standard, nach Anspruch 7, wobei die Kommunikationsschnittstelle eine UART-Kommunikation annimmt und eine Baud-Rate innerhalb eines Bereichs von 1200 bps bis 19200 bps adaptiv ist; und

mehr als ein Energieausgabeanschluss bereitgestellt ist, Energiedaten in einem Rechteckwellenmodus ausgegeben werden und ein High-Pegel einer Rechteckwelle 80 ms dauert; und ein Typ der Energiedaten, die durch den Energieausgabeanschluss ausgegeben werden, in der Lage ist, durch ein CF-Impulsausgabesteuerregister konfiguriert zu werden.

9. Intelligenter Internet-der-Dinge-Zähler, basierend auf einem IR46-Standard, umfassend ein Zählkernmodul, wobei das Zählkernmodul den Einphasen-Zählchip für elektrische Energie nach einem der Ansprüche 1 bis 8 und einen Zählhauptsteuerchip umfasst, und eine elektrische Trennschaltung mit einer Widerstandsspannungsfestigkeit von 4 KV zwischen dem Einphasen-Zählchip für elektrische Energie und dem Zählhauptsteuerchip verwendet wird.

**Revendications**

1. Puce de mesure de l'énergie électrique monophasée basée sur une norme IR46, comprenant une unité d'acquisition et de correction de signal de courant et de tension, une unité de mesure et de comptage pleine onde, une unité de mesure et de comptage d'harmoniques, une unité de traitement de données échantillonnées d'origine, une unité de mesure de température de borne, une interface de communication, une interface de sortie d'énergie et un port de sortie de données de forme d'onde d'origine, dans laquelle,

l'unité d'acquisition et de correction de signal de courant et de tension est configurée pour effectuer une conversion analogique-numérique sur un signal de tension et un signal de courant, et effectuer une correction de phase et de gain sur les signaux soumis à la conversion analogique-numérique pour obtenir des données corrigées du signal de tension et des données corrigées du signal de courant ;

les données corrigées comprennent une valeur moyenne de composante de courant continu, des données non passe-haut, des données passe-haut, des données échantillonnées de manière asynchrone et des données échantillonnées de manière synchrone d'un signal correspondant, et les données échantillonnées de manière asynchrone et les données échantillonnées de manière synchrone sont sorties dans un mode DMA ;

l'unité de mesure et de comptage pleine onde est configurée pour calculer et obtenir des données pleine onde en fonction des données corrigées du signal de tension et des données corrigées du signal de courant, et les données pleine onde comprennent une valeur efficace pleine onde, une puissance pleine onde, une fréquence de réseau, un facteur de puissance et des données d'énergie pleine onde ;

l'unité de mesure et de comptage d'harmoniques est configurée pour calculer et obtenir des données d'harmoniques en fonction des données corrigées du signal de tension et des données corrigées du signal de courant, et les données d'harmoniques comprennent une valeur effective d'harmonique, une puissance d'harmonique et des données d'énergie d'harmonique ;

l'unité de traitement de données de forme d'onde d'origine est configurée pour traiter les données corrigées du signal de tension et/ou les données corrigées du signal de courant pour obtenir des données de forme d'onde ;

l'unité de mesure de température de borne comprend l'acquisition et la correction d'un signal de mesure de température, et est configurée pour mesurer et surveiller les températures de quatre bornes de fil d'un compteur d'énergie électrique pour obtenir des données de mesure de température de borne ;

l'interface de communication est configurée pour communiquer avec une puce de commande principale de mesure, et la puce de commande principale de mesure commande la puce de mesure de l'énergie électrique monophasée via l'interface de communication, et lit les données pleine onde, les données d'harmoniques et les données de mesure de température de borne ;

l'interface de sortie d'énergie est configurée pour sortir les données d'énergie pleine onde et les données d'énergie harmonique ; et

le port de sortie de données de forme d'onde d'origine est configuré pour sortir les données de forme d'onde dans un mode de sortie actif ;

l'unité d'acquisition et de correction de signal de courant et de tension comprend une première sous-unité d'acquisition et de correction,

la première sous-unité d'acquisition et de correction comprend un premier convertisseur analogique-numérique et un canal de signal de tension, le premier convertisseur analogique-numérique est configuré pour effectuer la conversion analogique-numérique sur le signal de tension pour obtenir un signal numérique de tension ; et le canal de signal de tension est configuré pour effectuer la correction de phase et de gain sur le signal numérique de tension pour obtenir les données corrigées du signal de tension ;

le canal de signal de tension comprend un circuit de correction de mesure, et le circuit de correction de mesure comprend un circuit de correction de phase, un circuit de sous-échantillonnage, un filtre passe-bas (81), un filtre passe-haut (82), un circuit de compensation automatique en courant continu, une première unité arithmétique (83), un circuit de correction de gain et un premier sélecteur (85),

le circuit de correction de phase est configuré pour effectuer une correction de phase de mesure sur le signal numérique de tension pour obtenir des données corrigées en phase de mesure ;

le circuit de sous-échantillonnage est configuré pour effectuer un sous-échantillonnage sur les données corrigées en phase de mesure pour obtenir des données sous-échantillonnées ;

le filtre passe-bas (81) est configuré pour effectuer un filtrage passe-bas sur les données sous-échantillonnées pour obtenir une valeur moyenne de composante de courant continu du signal de tension ;

le circuit de compensation automatique de courant continu est configuré pour effectuer une compensation de courant continu sur la valeur moyenne de composante de courant continu du signal de tension pour obtenir des données compensées en courant continu ; et lorsque le circuit de compensation automatique de courant continu est désactivé, les données compensées en courant continu sont nulles ;

la première unité arithmétique (83) est configurée pour soustraire les données compensées en courant continu des données sous-échantillonnées pour obtenir une première valeur arithmétique ;

le filtre passe-haut (82) est configuré pour effectuer un filtrage passe-haut sur les données sous-échantillonnées pour obtenir une deuxième valeur de composante de courant alternatif ;

le circuit de correction de gain est configuré pour effectuer une correction de gain de mesure sur la première valeur arithmétique et la deuxième valeur de composante de courant alternatif respectivement, et après que la première valeur arithmétique traverse le circuit de correction de gain, des données non passe-haut du signal de tension sont obtenues ; et après que la deuxième valeur de composante de courant alternatif traverse le circuit de correction de gain, des données passe-haut du signal de tension sont obtenues ; et

le premier sélecteur (85) est configuré pour sélectionner les données non passe-haut du signal de tension ou les données passe-haut du signal de tension pour obtenir des données échantillonnées de manière asynchrone du signal de tension.

2. Puce de mesure de l'énergie électrique monophasée basée sur la norme IR46 selon la revendication 1, dans laquelle le signal de courant comprend un signal de courant de fil sous tension et un signal de courant de fil nul, et l'unité d'acquisition et de correction de signal de courant et de tension comprend également une deuxième sous-unité d'acquisition et de correction et une troisième sous-unité d'acquisition et de correction,

la deuxième sous-unité d'acquisition et de correction et la troisième sous-unité d'acquisition et de correction comprennent toutes deux un premier convertisseur analogique-numérique, un intégrateur numérique et un canal de signal de courant, et le canal de signal de courant et le canal de signal de tension ont la même structure ; la deuxième sous-unité d'acquisition et de correction est entrée avec le signal de courant de fil sous tension et sort des données corrigées du signal de courant de fil sous tension ; et la troisième sous-unité d'acquisition et de correction est entrée avec le signal de courant de fil nul et sort des données corrigées du signal de courant de fil nul.

**3.** Puce de mesure de l'énergie électrique monophasée basée sur la norme IR46 selon la revendication 2, dans laquelle le canal de signal de tension comprend en outre un circuit de correction de forme d'onde, et le circuit de correction de forme d'onde comprend un circuit de correction de phase, un circuit d'échantillonnage synchrone, une deuxième unité arithmétique (84) et un circuit de correction de gain,

le circuit de correction de phase est en outre configuré pour effectuer une correction de phase de forme d'onde sur le signal numérique de tension pour obtenir des données corrigées en phase de forme d'onde ;
le circuit d'échantillonnage synchrone est configuré pour effectuer un échantillonnage synchrone sur les données corrigées en phase de forme d'onde pour obtenir des données échantillonnées de manière synchrone ;
la deuxième unité arithmétique (84) est configurée pour soustraire les données compensées en courant continu des données échantillonnées de manière synchrone pour obtenir une troisième valeur arithmétique ; et
le circuit de correction de gain est en outre configuré pour effectuer une correction de gain de forme d'onde sur la troisième valeur arithmétique pour obtenir des données échantillonnées de manière synchrone du signal de tension.

**4.** Puce de mesure de l'énergie électrique monophasée basée sur la norme IR46 selon la revendication 3, dans laquelle la valeur effective d'harmonique comprend des valeurs effectives de courant et de tension d'harmonique d'ordre M et d'harmonique totale, la puissance d'harmonique comprend une puissance active et réactive d'harmonique d'ordre M et d'harmonique totale, et les données d'énergie harmonique comprennent des données d'énergie active et réactive d'harmonique d'ordre M et d'harmonique totale ; et M représente un nombre total d'ondes harmoniques, et $1 \leq M \leq 41$ ;

l'unité de mesure et de comptage d'harmoniques comprend une sous-unité d'algorithme FFT, un circuit de compensation de gain de données d'harmoniques d'ordre 1 à M et un circuit d'intégration d'énergie,
les données échantillonnées de manière synchrone du signal de tension et les données échantillonnées de manière synchrone du signal de courant sont placées dans une zone tampon de données à l'intérieur de la puce de mesure de l'énergie électrique monophasée en tant que sources de données, et la sous-unité d'algorithme FFT effectue une opération harmonique sur les données échantillonnées de manière synchrone du signal de tension et les données échantillonnées de manière synchrone du signal de courant une période $T_{FFT}$ sur deux pour obtenir des résultats d'opération d'harmonique ;
le circuit de compensation de gain de données d'harmoniques d'ordre 1 à M effectue une compensation de gain sur les résultats d'opération d'harmonique pour obtenir des valeurs efficaces de courant et de tension d'harmoniques d'ordre M, une puissance active d'harmonique d'ordre M et une puissance réactive d'harmonique d'ordre M respectivement ; et
le circuit d'intégration d'énergie effectue une opération d'intégration d'énergie sur la puissance active d'harmonique d'ordre M et la puissance réactive d'harmonique d'ordre M respectivement, et après que la puissance active d'harmonique d'ordre M traverse le circuit d'intégration d'énergie, les données d'énergie active d'harmonique d'ordre M et d'harmonique totale sont obtenues ; et après que la puissance réactive d'harmonique d'ordre M traverse le circuit d'intégration d'énergie, les données d'énergie réactive d'harmonique d'ordre M et d'harmonique totale sont obtenues.

**5.** Puce de mesure de l'énergie électrique monophasée basée sur la norme IR46 selon la revendication 4, dans laquelle l'unité de mesure de température de borne comprend une sous-unité de sélection de canal, un deuxième convertisseur analogique-numérique, un circuit de gain analogique et des premier à quatrième circuits de correction de gain,

la sous-unité de sélection de canal est configurée pour sélectionner un signal de température de borne à partir d'une première borne de fil sous tension, d'une seconde borne de fil sous tension, d'une première borne de fil nul et d'une seconde borne de fil nul pour entrer dans le second convertisseur analogique-numérique ;
le second convertisseur analogique-numérique est configuré pour effectuer une conversion analogique-numérique sur le signal de température de borne pour obtenir un signal numérique de température de borne ;
le circuit de gain analogique est configuré pour obtenir une valeur de gain de température de borne à partir du signal numérique de température de borne ; et
les premier à quatrième circuits de correction de gain sont configurés pour effectuer une correction de gain sur une première valeur de gain de température de borne de fil sous tension, une seconde valeur de gain de température de borne de fil sous tension, une première valeur de gain de température de borne de fil nul et une seconde valeur de gain de température de borne de fil nul respectivement pour obtenir des valeurs efficaces de température correspondantes.

6.  Puce de mesure de l'énergie électrique monophasée basée sur la norme IR46 selon la revendication 5, dans laquelle un nombre de points d'échantillonnage de chaque cycle du premier convertisseur analogique-numérique est $N_{ADC1}$, $N_{ADC1} \geq 128$, et la précision du premier convertisseur analogique-numérique est de 22 bits, de sorte que les données corrigées du signal de tension et les données corrigées du signal de courant sont de 22 bits.

7.  Puce de mesure de l'énergie électrique monophasée basée sur la norme IR46 selon la revendication 6, dans laquelle l'unité de traitement de données de forme d'onde d'origine comprend une sous-unité de sélection de canal, une sous-unité de traitement de nombre de points de sortie et une sous-unité de traitement d'encadrement de données,

    la sous-unité de sélection de canal est configurée pour sélectionner les données de forme d'onde pour sortir les données corrigées du signal de tension et/ou les données corrigées du signal de courant, et sélectionner les données échantillonnées de manière asynchrone ou les données échantillonnées de manière synchrone dans les données corrigées ; et l'unité d'acquisition et de correction de signal de courant et de tension envoie les données échantillonnées de manière asynchrone ou les données échantillonnées de manière synchrone à la sous-unité de sélection de canal une fois que chaque point d'échantillonnage est terminé, et les données échantillonnées de manière asynchrone ou les données échantillonnées de manière synchrone sont toutes deux représentées par trois octets ;
    la sous-unité de traitement du nombre de points de sortie est configurée pour sélectionner un nombre de points de sortie en fonction du nombre de points d'échantillonnage sortis par les données échantillonnées de manière asynchrone ou les données échantillonnées de manière synchrone à chaque cycle pour obtenir les données échantillonnées de manière asynchrone ou les données échantillonnées de manière synchrone après le traitement du nombre de points de sortie ; lorsque $128 \leq N_{ADC1} < 256$, le nombre de points de sortie est de 128 ; et lorsque $N_{ADC1} \geq 256$, le nombre de points de sortie est de 128 ou 256 ;
    la sous-unité de traitement d'encadrement de données est configurée pour effectuer un traitement d'encadrement de données sur les données échantillonnées de manière asynchrone ou les données échantillonnées de manière synchrone après traitement du nombre de points de sortie, et un format de données de forme d'onde après traitement est : en-tête de trame+U+IA+IB+somme de contrôle ;
    où,
    l'en-tête de trame est d'un octet ;
    U représente les données corrigées du signal de tension, $U = U\_Byte0 + U\_Byte1 + U\_Byte2$, et $U\_Byte0$ à $U\_Byte2$ représentent respectivement trois représentations en octets des données corrigées du signal de tension ;
    Ia représente les données corrigées du signal de courant de fil sous tension, $Ia = Ia\_Byte0 + Ia\_Byte1 + Ia\_Byte2$, et $Ia\_Byte0$ à $Ia\_Byte2$ représentent respectivement trois représentations d'octets des données corrigées du signal de courant de fil sous tension ;
    Ib représente les données corrigées du signal de courant de fil nul, $Ib = Ib\_Byte0 + Ib\_Byte1 + Ib\_Byte2$, et $Ib\_Byte0$ à $Ib\_Byte2$ représentent respectivement trois représentations d'octets des données corrigées du signal de courant de fil nul ;
    U+Ia+Ib est ajusté selon une configuration d'un registre de commande de sortie de données d'origine échantillonnées ; et
    la somme de contrôle est l'inverse d'une somme accumulée des données corrigées du signal de tension et/ou des données corrigées du signal de courant, plus 0x33.

8.  Puce de mesure de l'énergie électrique monophasée basée sur la norme IR46 selon la revendication 7, dans laquelle l'interface de communication adopte une communication UART, et un débit en bauds est adaptatif dans une plage de 1200 bps à 19200 bps ; et
    plusieurs ports de sortie d'énergie sont prévus, les données d'énergie sont sorties en mode onde carrée, et un niveau élevé d'une onde carrée dure 80 ms ; et un type des données d'énergie sortie par le port de sortie d'énergie peut être configuré par l'intermédiaire d'un registre de commande de sortie d'impulsions CF.

9.  Compteur intelligent de l'Internet des objets basé sur une norme IR46, comprenant un module central de mesure, dans lequel le module central de mesure comprend la puce de mesure de l'énergie électrique monophasée selon l'une quelconque des revendications 1 à 8 et une puce de commande principale de mesure, et un circuit d'isolation électrique avec une intensité de tension de tenue de 4 KV est utilisé entre la puce de mesure de l'énergie électrique monophasée et la puce de commande principale de mesure.

FIG. 1

FIG. 2

FIG. 3

FIG. 4

FIG. 5

Metering chip

FIG. 6

FIG. 7

FIG. 8

FIG. 9

FIG. 10

## EP 4 310 517 B1

**Patent documents cited in the description**

- CN 214174475 U